# EUROPÄISCHE PATENTSCHRIFT

(11) **EP 2 010 867 B1**
(45) Veröffentlichungstag und Bekanntmachung des Hinweises auf die Patenterteilung: **31.05.2017**
(21) Anmeldenummer: 07728076.6
(22) Anmeldetag: 13.04.2007
(51) Int. Cl.: G01D 21/00, G01D 5/48, H03K 17/95

(54) **SENSOR FÜR EINE MESSSTELLE UND VERFAHREN ZUR ÜBERPRÜFUNG EINES SENSORS FÜR EINE MESSSTELLE**
SENSOR FOR A MEASURING POINT AND METHOD FOR INSPECTING A SENSOR FOR A MEASURING POINT
CAPTEUR POUR UN POINT DE MESURE ET PROCÉDÉ DE CONTRÔLE D'UN CAPTEUR POUR UN POINT DE MESURE

(30) Priorität: 26.04.2006 DE 102006020016; 28.04.2006 DE 102006020341; 21.06.2006 DE 102006028826
(43) Veröffentlichungstag der Anmeldung: 07.01.2009
(60) Teilanmeldung: 16164108.9
(73) Patentinhaber: Endress + Hauser Conducta GmbH+Co. KG, 70839 Gerlingen (DE)
(72) Erfinder: BABEL, Wolfgang, 71263 Weil der Stadt (DE); GEHRKE, Martin, 71384 Weinstadt (DE); WITTMER, Detlev, 75433 Maulbronn (DE); GOMMLICH, Andreas, 76185 Karlsruhe (DE)
(74) Vertreter: Andres, Angelika Maria
(86) Internationale Anmeldenummer: PCT/EP2007/053609
(87) Internationale Veröffentlichungsnummer: WO 2007/125020

(56) Entgegenhaltungen:
- WO-A-2005/031339
- DE-A1- 10 313 639
- US-A- 5 597 534
- US-A1- 2005 022 581
- US-B1- 6 294 997

## Beschreibung

Die Erfindung betrifft einen Sensor für eine Messstelle und Verfahren zur Überprüfung eines Sensors für eine Messstelle.

In der Prozessautomatisierungstechnik werden häufig Sensoren eingesetzt, die zur Erfassung von Messwerten dienen. In der Regel sind die Sensoren über einen Meßumformer mit einem Leitsystem verbunden, an das die Messdaten weitergeleitet werden. Die Kommunikation zwischen den Meßumformern und dem Leitsystem erfolgt nach einem der in der Prozessautomatisierungstechnik üblichen Standards, wie z. B. HART-Datenübertragung oder einem Feldbussystem (Foundation Fielbus, Profibus etc.). Neben diesen offenen Übertragungssystemen werden bei der digitalen Datenübertragung auch teilweise proprietäre Protokolle eingesetzt, dies insbesondere bei peer-to-peer Verbindungen zwischen Sensor und Meßumformer.

Bei gewissen Sensortypen sind die Sensoren vielfach aus zwei Komponenten aufgebaut, einem Sensorkopf und einem dazu passenden Sensorkopfgegenstück. Das an einer Messstelle vorgesehene Sensorkopfgegenstück ist fest mit dem Meßumformer verbunden, der Sensorkopf kann abgenommen werden. Diese Zweiteilung ist insbesondere bei Sensoren von Vorteil, die regelmäßig gewartet werden müssen.

Zur Reinigung oder Kalibrierung kann der Sensorkopf einfach an der Messstelle abgenommen werden, um in ein Labor transportiert zu werden, wo die Wartung durchgeführt wird.

Einen derartigen zweiteiligen Sensor bietet die Anmelderin (Endress + Hauser Conducta) unter dem Produktnamen Memosens® an. Dieses Produkt wird seit längerem von der Anmelderin hergestellt und vertrieben.

Problematisch bei derartigen Sensoren ist, dass nach dem Reinigen bzw. nach dem Kalibrieren der richtige Sensorkopf an der richtigen Messstelle mit dem Sensorkopfgegenstück wieder eingesetzt wird. Häufig führt der Anwender eine Box mit einem Satz von mehreren Sensorköpfen mit sich, aus dem der richtige Sensorkopf für die betreffende Messstelle ausgewählt werden muss. Hierzu sind die Sensorköpfe mit der Messstellenbezeichnung (TAG-Name) beschriftet, um dem Anwender die Zuordnung Sensorkopf - Messstelle zu erleichtern.

Aufgrund der manuellen Tätigkeit des Anwenders sind jedoch Verwechslungen nicht auszuschließen. Eine Verwechslung kann schwerwiegende Folgen haben. So darf ein Messkopf der an einer Cyanid-Messtelle eingesetzt war, unter keinen Umständen an einer Lebensmittel-Messstelle eingesetzt werden.

Ein falsch eingesetzter Messkopf kann z. B. zu Verunreinigungen des zu messenden Produktes führen und damit nachfolgende Verarbeitungsschritte des Produkts empfindlich beeinträchtigen.

Es sind heutzutage Anwendungen bekannt, wo Sensor und Meßumformer relativ weit auseinanderliegend angeordnet sind. Zukünftig sollen Sensoren auch ohne die Zwischenschaltung eines Meßumformers direkt mit dem Leitsystem verbunden werden können.

Ein falsch eingesetzter Sensorkopf kann prinzipiell am Meßumformer oder am Leitsystem angezeigt werden.

Wenn Sensor und Meßumformer bzw. Leitsystem relativ weit räumlich getrennt sind, ist jedoch eine solche Anzeige direkt an der Messstelle nicht möglich.

Zur Überprüfung müßte der Anwender bei jedem Austausch einen relativ weiten Weg zurücklegen. Diese Art der Überprüfung ist aber bei Sätzen von ca. 20 Sensorköpfen äußerst zeitaufwendig, da der Anwender mehrere Male das Leitsystem aufsuchen muss, um den richtigen Einsatz eines Sensorkopfs zu überprüfen.

Alle bisher bekannte Prüfverfahren bergen mögliche Fehlerquellen, die ein absolut zuverlässiges Einsetzen der Sensorköpfe an der richtigen Messstelle nicht gewährleisten.

Zukünftig soll der Austausch der Messköpfe eine Routinetätigkeit sein, die nicht unbedingt von Fachpersonal durchgeführt werden muss. Dadurch werden noch höhere Anforderungen an den sicheren Austausch gestellt. WO2005031339 A1 beschreibt einen Flüssigkeits- oder Gassensor, der aus einem Sensormodul und einem Sensormodulkopf gebaut ist, die steckbar miteinander verbindbar sind und die im zusammengesetzten Zustand einen Daten- und Energieaustausch über eine galvanisch entkoppelte Übertragungsstrecke ermöglichen. Ein Steckmodul ist vorgesehen , das mit dem Sensormodul bzw. dem Sensormodulkopf verbindbar ist und zur Anzeige von im Sensormodul gespeicherten Sensordaten bzw. zur Simulation eines Messwertes dient.

Aufgabe der Erfindung ist es deshalb einen Sensor für eine Messstelle und ein Verfahren zur Überprüfung eines Sensors für eine Messstelle anzugeben, der bzw. das die oben genannten Nachteile nicht aufweist, wobei insbesondere ein sicherer Austausch von Messköpfen bei Sensorn gewährleistet ist und der Anwender einen Fehler beim Einsetzen eines falschen Sensorkopfs unmittelbar signalisiert bekommt.

Gelöst wird diese Aufgabe durch folgende im Anspruch 1 angegebenen Merkmale bzw. durch die im Anspruch 4 angegebenen Verfahrenschritte.

Nachfolgend ist die Erfindung anhand eines Ausführungsbeispiels näher erläutert.

Es zeigen:
Fig. 1 schematische Darstellung von mehreren Sensoren
   die mit einem Leitsystem verbunden sind,
Fig. 2 schematische Darstellung eines zweiteiligen Sensors
   mit Sensorkopf und Sensorkopfgegenstück

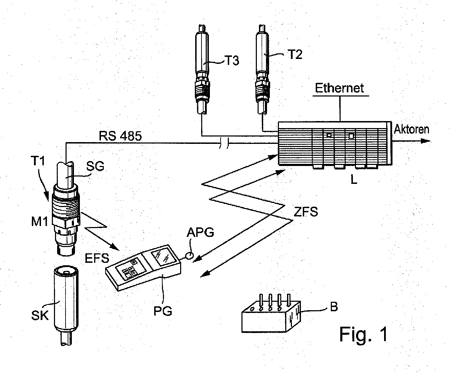

In Fig. 1 ist ein Leitsystem L dargestellt, das mit mehreren Sensorn T1, T2, T3 über entsprechende Kabel K1, K2, K3 verbunden ist. Die Sensor T1, T2, T3 sind jeweils entsprechenden Messstellen M1, M2, M3 zugeordnet. Die Kommunikation zwischen den Sensorn und dem Leitsystem erfolgt über eine serielle Datenkommunikation mit einem "physical layer" nach der RS 485 Standard. Mit dem Leitsystem L sind auch nicht näher dargestellte Aktoren verbunden. Bei dem Leitsystem L kann es sich um eine SPS-Einheit (Speicherprogrammierbare Steuerung) bzw. um eine dezentrale Steuerung DCS (Distributed Control System) handeln. Häufig ist das Leitsystem L auch an ein lokales Netzwerk (Ethernet) angeschlossen, das einen anlagen-/firmenweiten Datenaustausch ermöglicht.

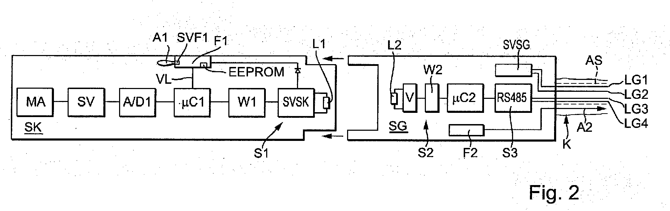

In Fig. 2 ist ein Blockschaltbild eines erfindungsgemäßen Sensors dargestellt, der aus zwei Komponenten, einem Sensorkopf SK und einem Sensorkopfgegenstück SG, besteht. Diese beiden Komponenten sind über eine einfach zu lösende Bajonettverschraubung miteinander verbunden.

Der Sensorkopf SK besteht im Wesentlichen aus einem Messaufnehmer MA, der zur Erfassung einer physikalischen Messgröße z. B. pH-Wert, Temperatur etc. dient. Dem Messaufnehmer MA ist eine analoge Signalverarbeitungseinheit SV nachgeschaltet, in dem das analoge Messsignal vorverarbeitet z. B. gefiltert oder verstärkt wird. Über einem Analog/Digital-Wandler A/D 1 wird das Messsignal einem Mikrocontroller µC1 zugeführt, in dem eine weitere Verarbeitung des Messsignals stattfindet. Über eine Kommunikationsschnittstelle S1 kann der Mikrocontroller µC1 Daten senden und empfangen. Die Kommunikationsschnittstelle S1 besteht aus einem Wandler W1 und einer Spannungsversorgungseinheit SVSK und einer Spule L1.

Passend zum Sensorkopf SK ist ein Sensorkopfgegenstück SG ausgebildet. Beide sind über eine nicht näher dargestellte Bajonettverbindung miteinander einfach lösbar zu verbinden.

Das Sensorkopfgegenstück SG weist eine zur Kommunikationsschnittstelle S1 entsprechende Gegenstelle, die Kommunikationsschnittstelle S2, auf. Diese besteht aus einer Spule L2 einem Verstärker V und einem Wandler W2. Der Wandler W2 ist mit einem Mikrocontroller µC2 verbunden. Die Kommunikation mit dem Leitsystem L erfolgt kabelgebunden über eine Kommunikationsschnittstelle S3, die z. B. aus einem RS-485 Baustein besteht. Das Kabel K weist 4 Leitungen LG1, LG2, LG3, LG4, die von einer Abschirmung AS umgeben sind. Zwei Leitungen sind für die Kommunikation und zwei Leitungen für die Energieübertragung zum Sensorkopfgegenstück SG vorgesehen.

Zur Energieversorgung des Sensorkopfgegenstücks SG dient eine Spannungsversorgungseinheit SVE, die über die Leitungen LG1 und LG2 vom Leitsystem L aus versorgt wird.

Der bisher beschriebene Aufbau entspricht dem bekannten Memosens-Sensor.

Die Datenübertragung zwischen den beiden Kommunikationsschnittstellen S1 und S2 erfolgt über eine induktive Kopplung. Gleichzeitig wird über diese Verbindung auch Energie kabellos zum Sensorkopf SK übertragen. Diese Energie wird in der Spannungsversorgungseinheit SVSK gewandelt und in eine entsprechende Versorgungsspannung für die einzelnen Bauelemente umgewandelt.

Zwischen dem Leitsystem L und dem Sensor (Sensorkopfgegenstück bzw. Sensorkopf) werden verschiedene Messdaten, Parametrierdaten und sensorspezifische Daten übertragen z.B. Sensorkennung mit Seriennummer, Produktionsdatum, Hardware- und Software-Version, Messwerte mit Hauptmesswertund Nebenmesswert (i.d.R Temperatur), Kalibrierdaten mit Offset/Steigung, Datum/Uhrzeit, Kalibrationsmethode, Sensorzustand mit Verwendungsdauer unter Extrembedingungen, Kalibrierzyklen, Hilfsparameter zur Zustandsbewertung,

Informationen zur Messstelle wie TAG-Nummer, Informationen zum Sensorelement am Sensorkopf wie Meßumfang, Erstinbetriebnahme, Charge.

Bei dem beschriebenen Ausführungsbeispiel sind Sensorkopf SK und Sensorkopfgegenstück SG vollkommen galvanisch getrennt. Diese galvanische Trennung ist insbesondere bei der pH-Messung von großem Vorteil, aber für die vorliegende Erfindung nicht unbedingt erforderlich.

Zum Kalibrieren wird der Sensorkopf SK vom Sensorkopfgegenstück SG abgeschraubt und an einem von der Messstelle M1 entfernten Labor transportiert, wo die eigentliche Kalibrierung stattfindet. Dies kann automatisiert erfolgen und die Kalibrierwerte zu jedem Sensorkopf werden eineindeutig zuordenbar in einer Datenbank abgespeichert. Diese Datenbank kann z. B. auch an das lokale Netzwerk angeschlossen sein. Anschließend muss der Sensorkopf an der Messstelle wieder eingesetzt werden, von der er entnommen wurde. Dem Anwender steht beim Austausch der Sensorköpfe eine Box B mit mehreren Sensorköpfen zur Verfügung. Eine solche Box B ist in Fig. 1 sehr stilisiert dargestellt.

Erfindungsgemäß weist der Sensorkopf SK eine Antenne A1 und eine angeschlossenen Funkeinheit F1 auf. Die Funkeinheit F1 kann entweder mit dem Mikrocontroller µCl über die Verbindungsleitung VL verbunden sein oder in einer alternativen Ausgestaltung keine Verbindung zum Mikrocontroller µC1 aufweisen. Die Funkeinheit F1 entspricht einem Transponder, wie sie vielfach in der RFID-Technologie eingesetzt werden. Die Funkeinheit F1 ist dafür ausgelegt ohne fremde Energieversorgung nur mit Hilfe der Funkenergie zu arbeiten.

Zusätzlich ist die Funkeinheit F1 noch mit der Spannungsversorgungseinheit SVSK verbunden. Dadurch können Daten aus einem in der Funkeinheit F1 vorgesehenen Speicher (EEPROM-Speicher mit 512 Byte Speicherplatz) auch ausgelesen werden, wenn keine Funkenergie zur Verfügung stehen sollte.

Weiterhin ist im Sensorkopfgegenstück SG eine Funkeinheit F2 vorgesehen, die mit dem Mikrocontroller µC2 verbunden ist. Die Antenne A2 der Funkeinheit F2 ist im Kabel K außerhalb der Abschirmung AS vorgesehen.

Nachfolgend ist die Funktionsweise des Sensors für die verschiedenen alternativen Ausgestaltungen näher erläutert.

Der Sensorkopf SK ist nicht mit dem Sensorkopfgegenstück verbunden.

An der Messstelle M1 kann der Anwender, bevor er den Sensorkopf SK aufsetzen will, mit Hilfe eines tragbaren Prüfgeräts PG Daten aus dem noch nicht zusammengesetzten Sensor T1 ermitteln.

Hierzu fragt das tragbare Prüfgerät PG, die Kennung des Sensorkopfs SK, die im Speicher EEPROM der Funkeinheit F1 gespeichert ist ab. Die Energieversorgung der Funkeinheit erfolgt bei der Abfrage über diese Funkstrecke (erste Funkstrecke EF1). Die Kennung wird anschließend an das Leitsystem L über eine zweite längere Funkstrecke EF2 übertragen. Anhand der Kennung ermittelt das Leitsystem L die Messstelle für die dieser Sensorkopf SK vorgesehen ist. Anschließend werden messstellenspezifische Daten an die Prüfeinheit PG übertragen und an dieser dargestellt. Diese Daten helfen dem Anwender, den richtigen Sensorkopf SK an der richtigen Messstelle, hier die Messstelle M1, einzusetzen.

Hierzu wird wieder die Kennung des Sensorkopfs SK vom Prüfgerät PG wie oben beschrieben ausgelesen. Anhand der Kennung ermittelt das Leitsystem L die entsprechende Messstelle M1 für die der Sensorkopf SK vorgesehen ist. Nun fragt das Leitsystem L die entsprechende Messstelle M direkt über die Kabelverbindung ab, und ermittelt so die Kennung des tatsächlich an dieser Messstelle M1 eingesetzten Sensorkopfs SK. Wenn der Sensorkopf SK an der richtigen Messstelle eingesetzt wurde, müssen die Kennung die vom Prüfgerät PG ans Leitsystem L übertragen wurde und die vom Leitsystem L ermittelte Kennung übereinstimmen. Stimmen beide Kennungen überein so wird eine entsprechende Klarmeldung ("Messstelle o. k.") vom Leitsystem L an das Prüfgerät PG gesendet.

Diese Information wird dem Anwender an der Messstelle M1 direkt angezeigt. Damit sieht der Anwender unmittelbar, dass der richtige Sensorkopf an dieser Messstelle eingesetzt wurde.

Falls ein falscher Sensorkopf eingesetzt wurde, stimmen die beiden Kennungen nicht überein, und das Leitsystem L sendet in diesem Fall eine entsprechende Fehlermeldung ("falscher Sensorkopf") an das Prüfgerät PG.

Damit wird ein fehlerhaftes Einsetzen eines Sensorkopfs an einer Messstelle einfach und zuverlässig vermieden. Der Anwender sieht somit unmittelbar nach dem Einbau, ob er den richtigen Sensorkopf an der vorgesehenen Messstelle eingesetzt hat.

Für den Fall, dass der Sensor T1 in einem metallischen Behälter angeordnet ist, ragt nach dem Einbau nur noch das Ende des Sensorkopfgegenstücks aus dem Behälter heraus. Eine Kommunikation zwischen Funkeinheit F1 und dem Prüfgerät PG, das sich außerhalb des Behälters befindet, ist nun nicht mehr möglich.

In diesen Fall kommt die Funkeinheit F2 zum Einsatz. Die Kommunikation erfolgt nun zwischen Prüfgerät PG und Funkeinheit F2. Die Funkeinheit F2 fordert die Kennung des Sensorkopfs über den Mikrocontroller µC2 vom Sensorkopf SK an. Das Auslesen der Kennung aus dem EEPROM-Speicher der Funkeinheit F1 ist deshalb möglich, da die Funkeinheit F1 direkt mit dem Mikrocontroller µC1 kommunizieren kann, der über die Spannungsversorgungseinheit SVSK versorgt wird. Da der Sensorkopf SK in einen metallischen Behälter ragt, kann aufgrund der Abschirmung keine Funkenergie an die Funkeinheit F1 übertragen werden. In diesem Fall kann der Sensorkopf auch im eingebauten Zustand vom Anwender identifiziert werden

Sind mehrere Messstellen M1, M2, M3 relativ nahe beieinander angeordnet, so tritt das Problem auf, dass das Prüfgerät PG mit Funkeinheiten von verschiedenen Messstellen in Kontakt treten kann. Der Anwender ist in diesem Fall nicht ganz sicher mit welcher Messstelle das Prüfgerät PG tatsächlich kommuniziert. Die Information "Messstelle o. k." könnte prinzipiell auch von einer benachbarten Messstelle stammen und nicht von der Messstelle, die der Anwender eigentlich prüfen will.

Aus diesem Grund weist das Prüfgerät erfindungsgemäß eine zangenförmige Antenne APG auf, die um die Antenne A2 gelegt werden muss, um eine Kommunikation mit genau diesem Sensor zu ermöglichen.

Damit kann der Anwender sicher sein, dass die Prüfung der richtigen Messstelle mit dem unmittelbar vor ihm befindlichen Sensor T1 erfolgt. Verwechslungen sind dadurch absolut ausgeschlossen.

Die Erfindung eignet sich nicht nur für den Austausch von Sensorköpfen sondern auch für den erstmaligen Einsatz. In diesem Fall muss nur sichergestellt werden, dass im Leitsystem L die Messstelle mit der Kennung des entsprechenden Sensorkopf bereits gespeichert sind.

Das Prüfgerät PG ist prinzipiell für zwei unterschiedliche Funkkommunikationsmethoden ausgelegt. Zum einen die Kommunikation mit der Funkeinheit F1 entsprechend der RFID-Technik und zum anderen mit der Funkeinheit F2 oder dem Leitsystem L zum Beispiel nach dem ZigBee-Standard.

Nachfolgend besteht die Verbindung über die Verbindungsleitung VL zwischen Funkeinheit F1 und Mikrocontroller µC1 nicht. In der Funkeinheit F1 und im Mikrocontroller µC1 sind eine Unique ID-Kennung gespeichert. Bei der Produktion des Sensorkopfs SK muss gewährleistet werden, dass diese beiden Kennungen gleich sind.

Über diese Unique ID-Kennung kann die Seriennummer des Sensorkopfs SK ermittelt werden und damit Daten zu dem betreffenden Sensorkopf aus einer Datenbank abgerufen werden. Die Datenbank kann z. B. direkt im Prüfgerät PG gespeichert sein. Sollte dies nicht der Fall sein, so kann alternativ die Datenbankabfrage auch über die Funkstrecke ZFS erfolgen.

In jedem Fall können Sensordaten z. B. der Messwert auch direkt über die Funkeinheit F1 bzw. F2 aus dem Sensor ausgelesen werden.

Für den Anwender gibt es eine zusätzliche Sicherheit, wenn er vor Ort den Messwert mit Hilfe des Prüfgeräts PG abfragen kann und anschließend in der Warte überprüfen kann. Stimmen beide überein so gibt dies zusätzliche Sicherheit.

Nachfolgend sind noch einmal alle Anwendungsfälle der Erfindung systematisch aufgeführt. Die Erfindung betrifft generell die Kommunikation mit einem Sensor über die erste Funkstrecke EFS. Hierbei werden zwei Methoden beachtet: 1. Kommunikation mit der Funkeinheit F1 und Versorgung der Funkeinheit F1 aus dem Funkfeld; 2. Kommunikation über einen Nahbereichsfunk (zum Beispiel Zigbee, Nanonet o.a.) mit der Funkeinheit F2 im Sensorkopfgegenstück SG.

Für die Kommunikation nach der ersten Methode gibt es unterschiedliche Anwendungsfälle: 1. Die Funkeinheit F1 hat keine Verbindung zum Mikrocontroller µC1 und zur Spannungsversorgungseinheit SVSK. Spezielle Sensordaten sind im EEPROM gespeichert und nur über den Mikrocontroller µC1 zugreifbar. Hierbei sind folgende Spezialfälle denkbar: 1.1 Der Sensor ist in der Box B und nicht mit dem Sensorkopfgegenstück SG verbunden. Es erfolgt die Abfrage einer Kennung des Sensors (Unique ID) mit Versorgung durch das Funkfeld aus dem Sensorkopf SK. Die Unique ID wird in eine Messstellennummer oder Sensornummer durch eine im Prüfgerät PG vorgesehene Datenbank umgewandelt. Mit diesen Informationen kann eine Anfrage der Korrektheit der Messstelle über die zweite Funkstrecke ZFS an das Leitsystem L erfolgen. Alternativ kann hierzu eine direkte Anfrage unter Verwendung der Unique ID über die zweite Funkstrecke ZFS beim Leitsystem L auf Korrektheit der Verwendung erfolgen. Die Anzeige der Antwort erfolgt über die zweite Funkstrecke ZFS auf dem Prüfgerät PG.
1.2 Nun wird der Fall betrachtet, dass der Sensor am Kabel K über das Sensorkopfgegenstück SG angeschlossen ist und keine Abschirmung durch die Armatur erfolgt. Hier erfolgt wieder eine Abfrage der Unique ID mit Versorgung durch das Funkfeld aus dem Sensorkopf SK. Die Unique ID wird in die Messstellennummer durch eine Datenbank im Prüfgerät PG umgeschlüsselt. Anschließend erfolgt eine Anfrage nach Sensordaten auch Messwerte über die zweite Funkstrecke ZVS an das Leitsystem L. Alternativ kann eine direkte Anfrage unter Verwendung der Unique ID über die zweite Funkstrecke ZVS beim Leitsystem L nach Sensordaten (auch Messwerte) erfolgen. Die Anzeige der Antwort erfolgt über die zweite Funkstrecke ZFS auf dem Prüfgerät PG.
1.3 Eine dritte Alternative ergibt sich, wenn der Sensor am Kabel über das Steckergegenstück SG angeschlossen ist, aber eine Abschirmung der ersten Funkstrecke EFS durch die Armatur erfolgt. Hier ist eine Abfrage der Sensordaten über die erste Funkstrecke via Antenne A2 und Funkeinheit F2 möglich. Die Abfrage wird über den Mikrocontroller µC2 in den von der Kommunikationsschnittstelle S3/LG3/LG4 kommenden Datenstrom über den Wandler W2 und den Verstärker V sowie die Spule L2 an dem Sensorkopf SK eingeschleust. Die Antwort vom Sensorkopf SK wird durch den Mikrocontroller µC2 ausgeschleust und die Antwort über die Funkeinheit F2 und die Antenne 2 an das Prüfgerät PG abgesetzt. Anschließend erfolgt die Anzeige der Antwort über die erste Funkstrecke EFS von der Funkeinheit F2 auf dem Prüfgerät PG.

Nun wird der zweite Anwendungsfall betrachtet.
2. Hier hat die Funkeinheit F1 eine elektrische Verbindung über die Verbindungsleitung VL zum Mikrocontroller µC1 und auch eine Verbindung zum Datenspeicher EEPROM und der Spannungsversorgungseinheit SVSK. Auch hier sind wieder folgende spezielle Anwendungsfälle denkbar:
   2.1 Der Sensor befindet sich in der Box B und ist nicht am Kabel über das Sensorkopfgegenstück SG angeschlossen. Die Abfrage der Sensordaten erfolgen direkt aus dem EEPROM des Sensorkopfs SK, welches Teil der Funkeinheit F1 ist. Die Versorgung erfolgt durch das Funkfeld. Anschließend erfolgt eine Anzeige der Antwort über die erste Funkstrecke EFS auf dem Prüfgerät PG.
   2.2 In einem weiteren Spezialfall ist der Sensor an Kabel K über das Sensorkopfgegenstück SG angeschlossen, wobei keine Abschirmung durch die Armatur erfolgt. Die Abfrage der Sensordaten und der Messwerte erfolgt direkt aus dem EEPROM und dem Mikrocontroller µC1 des Sensorkopfs SK, welcher Teil der Funkeinheit F1 ist. Auch hier erfolgt wieder die Versorgung durch das Funkfeld. Die Anzeige der Antwort erfolgt über die erste Funkstrecke EFS auf dem Prüfgerät PG.

Der Spezialfall 2.3 entspricht dem Fall 1.3.

### Bezugszeichenliste

**Tabelle 1**

| | |
|---|---|
| Analog/Digital-Wandler | A/D1 |
| Antenne | A1, A2 |
| Antenne Prüfgerät | APG |
| Erste Funkstrecke | EFS |
| Funkeinheit | F1, F2 |
| Kabel | K1, K2, K3 |
| Kommunikationsschnittstellen | S1, S2, S3 |
| Leitsystem | L |
| Messaufnehmer | MA |
| Messstelle | M1, M2, M3 |
| Mikrocontroller | mC1, mC2 |
| | |
| Sensorkopf | SK |
| Signalverarbeitungseinheit | SV |
| Spannungsversorgungseinheit | SVSG, SVF1, SVSK |
| Spule | L1, L2 |
| Sensorkopfgegenstück | SG |
| Tragbares Prüfgerät | PG |
| Sensor | T1, T2, T3 |
| Verstärker | V |
| Wandler | W1, W2 |
| Zweite Funkstrecke | ZFS |
| Verbindungsleitung | VL |

## Patentansprüche

1. Sensor für eine Messstelle bestehend aus einem Sensorkopf (SK) und einem Sensorkopfgegenstück (SG), die lösbar miteinander verbindbar sind, wobei der Sensorkopf (SK) einen Messaufnehmer (MA) zur Messwerterfassung, einen ersten Mikrocontroller (µC1) zur Messwertverarbeitung, eine Spannungsversorgungseinheit (SVSK) zur Energieversorgung des Sensorkopfs (SK) und eine Kommunikationsschnittstelle (S1) zum Datenaustausch mit dem Sensorkopfgegenstück (SG) aufweist, wobei das Sensorkopfgegenstück mit einem Leitsystem verbunden ist, an das die verarbeiteten Messwerte weitergeleitet werden,
**dadurch gekennzeichnet,**
**dass** der erste Mikrocontroller (µC1) mit einer Funkeinheit (F1) verbunden ist, die an die Spannungsversorgungseinheit (SVSK) des Sensorkopfs angeschlossen ist und die eine zusätzliche separate Spannungsversorgungseinheit SVF1 und einen Speicher aufweist,
wobei die zusätzliche separate Spannungsversorgungseinheit SVF1 über Funkenergie gespeist wird und dadurch einen Datenaustausch über Funk ermöglicht, auch wenn die Spannungsversorgungseinheit SVSK keine Energie für den Sensorkopf SK liefert.

2. Sensor nach Anspruch 1, **dadurch gekennzeichnet, dass** der Datenaustausch zwischen Sensorkopf (SK) und Sensorkopfgegenstück (SG) drahtlos erfolgt und dass die Energieversorgung der Spannungsversorgungseinheit (SVSK) des Sensorkopfs (SK) ebenfalls drahtlos erfolgt.

3. Sensor für eine Messstelle nach einem der vorhergehenden Ansprüche, wobei das Sensorkopfgegenstück (SG) eine Kommunikationsschnittstelle (S2) zur Datenkommunikation und/oder Energieübertragung mit dem Sensorkopf (SK), einen Mikrocontroller (µC2) und eine Kommunikationsschnittstelle (S2) zur Datenübertragung zum Leitsystem (L) aufweist, **dadurch gekennzeichnet, dass** der Mikrocontroller (µC2) mit einer Funkeinheit (F2) verbunden ist.

4. Verfahren zur Überprüfung eines Sensors für einer Messstelle der einen Sensorkopf (SK) und ein Sensorkopfgegenstück (SG) aufweist, die lösbar über eine Steckverbindung miteinander verbindbar sind, wobei das Sensorkopfgegenstück (SG) über eine Kabelverbindung (K) an eine Leitsystem (L) angeschlossen ist, mit folgenden Verfahrensschritten:
1. - Auslesen einer Kennung des Sensorkopfs (SK) über eine erste Funkstrecke (EFS) in ein tragbares Prüfgerät (PG);
2. - Übertragung der Kennung von dem Prüfgerät (PG) an das Leitsystem über eine zweite Funkstrecke (ZFS);
3. - Übertragung von messstellenspezifischen Daten vom Leitsystem (L) an das Prüfgerät (PG);
4. Darstellung der messstellenspezifischen Daten am Prüfgerät (PG).

5. Verfahren nach Anspruch 4, wobei Sensorkopf (SK) und Sensorkopfgegenstück (SG) verbunden sind, mit folgenden Verfahrensschritten:
5. - Abfrage der der Kennung des Sensorkopfs (SK) zugeordneten Messstelle (M1) vom Leitsystem (L);
6. - Falls die beiden Kennungen übereinstimmen, wird als messstellenspezifisches Datum, eine entsprechende Klarmeldung vom Leitsystem (L) an das Prüfgerät (PG) übertragen;
7. - Falls die beiden Kennungen nicht übereinstimmen, wird als messstellenspezifische Information eine entsprechende Fehlermeldung übermittelt.

## Claims

1. Sensor for a measuring point consisting of a sensor head (SK) and a sensor head counter-piece (SG), which can be detachably connected to one another, wherein the sensor head (SK) has a measuring sensor (MA) designed to record measured values, a first microcontroller (µC1) designed to process the measured values, a voltage supply unit (SVSK) designed to supply energy to the sensor head (SK), and a communication interface (S1) designed to exchange data with the sensor head counter-piece (SG), wherein the sensor head counter-piece is connected to a control system to which the processed measured values are forwarded, **characterized in that**
the first microcontroller (µC1) is connected to a radio unit (F1), which is connected to the voltage supply unit (SVSK) of the sensor head and which has an additional separate voltage supply unit (SVF1) and an accumulator, wherein the additional separate voltage supply unit (SVF1) is powered via radio energy and in this way enables the exchange of data via radio technology even if the voltage supply unit (SVSK) does not supply any energy for the sensor head (SK).

2. Sensor as claimed in Claim 1, **characterized in that** data exchange between the sensor head (SK) and the sensor head counter-piece (SG) is wireless and **in that** the energy supply of the voltage supply unit (SVSK) of the sensor head (SK) is also via wireless technology.

3. Sensor for a measuring point as claimed in one of the previous claims, wherein the sensor head counter-piece (SG) has a communication interface (S2) designed for data communication and/or energy transmission with the sensor head (SK), a microcontroller (µC2) and a communication interface (S2) for the transmission of data to the control system (L), **characterized in that** the microcontroller (µC2) is connected to a radio unit (F2).

4. Procedure for checking a sensor for a measuring point which has a sensor head (SK) and a sensor head counter-piece (SG), which can be detachably interconnected via a plug connection, wherein the sensor head counter-piece (SG) is connected to a control system (L) via a cable connection, said procedure comprising the following steps:
1. An identification code of the sensor head (SK) is read into a portable testing device (PG) via a first radio path (EFS);
2. The identification code is transmitted from the testing device (PG) to the control system via a second radio path (ZFS);
3. Data specific to the measuring point are transmitted from the control system (L) to the testing device (PG);
4. The data specific to the measuring point are visualized on the testing device (PG).

5. Procedure as claimed in Claim 4, wherein the sensor head (SK) and the sensor head counter-piece (SG) are connected, said procedure comprising the following steps:
5. The control system (L) polls the measuring point (M1) assigned to the identification code of the sensor head (SK);
6. If the two identification codes match, a clear message is sent by the control system (L) to the testing device (PG) as a data unit specific to the measuring point;
7. If the two identification codes do not match, an error message to this effect is transmitted as information specific to the measuring point.

## Revendications

1. Capteur destiné à un point de mesure constitué d'une tête de capteur (SK) et d'une contre-tête de capteur (SG) pouvant être reliées entre elles par une liaison amovible, la tête de capteur (SK) comportant un transmetteur de mesure (MA) destiné à l'acquisition de valeurs mesurées, un premier microcontrôleur (µC1) destiné au traitement des valeurs mesurées, une unité d'alimentation en tension (SVSK) destinée à l'alimentation en énergie de la tête de capteur (SK), et une interface de communication (S1) destinée à l'échange de données avec la contre-tête de capteur (SG), la contre-tête de capteur étant reliée avec un système de contrôle-commande, auquel sont transmises les valeurs mesurées traitées, **caractérisé**
**en ce que** le premier microcontrôleur (µC1) est relié avec une unité radio (F1), qui est raccordée à l'unité d'alimentation en tension (SVSK) de la tête de capteur et qui présente une unité d'alimentation en tension (SVF1) séparée supplémentaire et un accumulateur, l'unité d'alimentation en tension (SVF1) séparée supplémentaire étant alimentée via l'énergie radio, permettant ainsi un échange de données sans fil, même lorsque l'unité d'alimentation en tension (SVSK) ne fournit aucune énergie pour la tête de capteur (SK).

2. Capteur selon la revendication 1, **caractérisé en ce que** l'échange de données entre la tête de capteur (SK) et la contre-tête de capteur (SG) s'effectue sans fil et **en ce que** l'alimentation en énergie de l'unité d'alimentation en tension (SVSK) de la tête de capteur (SK) s'effectue également sans fil.

3. Capteur destiné à un point de mesure, selon l'une des revendications précédentes, la contre-tête de capteur (SG) comportant une interface de communication (S2) destinée à la communication de données et/ou à la transmission de l'énergie avec la tête de capteur (SK), un microcontrôleur (µC2) et une interface de communication (S2) destinée à la transmission de données vers le système numérique de contrôle-commande (L), **caractérisé en ce que** le microcontrôleur (µC2) est relié avec une unité radio (F2).

4. Procédé pour le contrôle d'un capteur destiné à un point de mesure comportant une tête de capteur (SK) et une contre-tête de capteur (SG), qui sont reliées entre elles de façon amovible par l'intermédiaire d'une connexion enfichable, la contre-tête de capteur (SG) étant raccordée via une connexion par câble (K) au système numérique de contrôle-commande (L), lequel procédé comporte les étapes suivantes :
1. Lecture d'un code d'identification de la tête de capteur (SK) dans un appareil de contrôle (PG) portable par l'intermédiaire d'une liaison radio (EFS) ;
2. Transmission du code d'identification de l'appareil de contrôle (PG) au système numérique de contrôle commande par l'intermédiaire d'une deuxième liaison radio (ZFS) ;
3. Transmission de données spécifiques aux points de mesure du système numérique de contrôle commande (L) à l'appareil de contrôle ;
4. Affichage des données spécifiques aux points de mesure sur l'appareil de contrôle (PG).

5. Procédé selon la revendication 4, pour lequel la tête de capteur (SK) et la contre-tête de capteur (SG) sont reliées, lequel procédé comporte les étapes suivantes :
5. Interrogation par le système numérique de contrôle commande (L) du code d'identification du point de mesure (M1) affecté à la tête de capteur (SK) ;
6. Si les deux codes coïncident, un message clair est transmis en tant que donnée spécifique au point de mesure, depuis le système numérique de contrôle commande (L) à l'appareil de contrôle (PG) ;
7. Si les deux codes ne coïncident pas, un message d'erreur correspondant est transmis en tant qu'information spécifique au point de mesure.
